Europäisches Patentamt

**European Patent Office**

**Office européen des brevets**

(11) Publication number: **0 179 670**
A2

# (12) EUROPEAN PATENT APPLICATION

(21) Application number: **85307744.4**

(22) Date of filing: **25.10.85**

(51) Int. Cl.⁴: **C 01 B 31/36**

(30) Priority: **25.10.84 JP 224450/84**

(43) Date of publication of application:
**30.04.86 Bulletin 86/18**

(84) Designated Contracting States:
**DE FR GB**

(71) Applicant: **SUMITOMO CHEMICAL COMPANY, LIMITED**
**15 Kitahama 5-chome Higashi-ku**
**Osaka-shi Osaka 541(JP)**

(72) Inventor: **Hashimoto, Tadanori**
**12-2, Tenno-cho**
**Takatsuki-shi Osaka(JP)**

(72) Inventor: **Nakano, Kazuhiko**
**3-1-34, Kouzu**
**Katano-shi Osaka(JP)**

(72) Inventor: **Matsuda, Norio**
**2-29-7, Oike**
**Ibaraki-shi Osaka(JP)**

(74) Representative: **Moore, Anthony John et al,**
**Gee & Co. Chancery House Chancery Lane**
**London WC2A 1QU(GB)**

(54) **Production of silicon carbide cobweb whiskers.**

(57) Silicon carbide cobweb whiskers are produced by heating a mixture of silicon dioxide powder, carbon powder and a catalyst composed of at least one of niobium, tantalum and compounds thereof in a non-oxidative gas at a temperature of from 1,400 to 1,900°C.

EP 0 179 670 A2

PRODUCTION OF SILICON CARBIDE COBWEB WHISKERS

This invention relates to a method of producing silicon carbide cobweb whiskers.

Silicon carbide fibrous materials have characteristics such as good thermal resistance, high strength and modulus, low specific gravity, and the like; and not only are they expected to be useful as a reinforcing material for fiber reinforced composite materials, but it is hoped they they will also prove useful as a thermal insulating material for use in a high temperature environment. Accordingly, if a mass production process for making them at low cost can be established, they will be capable of wide application.

Various attempts have been made to improve the production of silicon carbide fibrous materials; representative of such attempts are methods based on reductive carbonization of silicon dioxide using a catalyst such as Fe or Ni (as described in U.S. Patent 3,778,296, etc.), or using rice hulls as a starting material (as described in U.S. Patent 4,248,844, etc.). However, in most of the former methods a silicon carbide fibrous material is adhered and grown as a crystal on the surface of the inner wall of a reaction tube, and relatively long particle-free fibers are obtained. These methods have had the drawback that the yield was very low.

Also, in the methods of reducing silicon dioxide using
Fe, Ni, or the like as a catalyst, not only does silicon
carbide fiber grow in gaps between particles of carbon
powder raw material, but also silicon carbide powder is
produced simultaneously.  Thus it is difficult to obtain
a homogenous silicon carbide fibrous material.  On the
other hand, in the latter methods, since silicon carbide
powder is produced together with a fibrous material, it is
necessary to separate the fibrous material from the powder.
Accordingly, these methods had defects such as low yield
and the difficulty of obtaining homogeneous fibrous
material free from powder.  Furthermore, cobweb whiskers
of silicon carbide have not previously been reported.

An object of the present invention is to provide
a method for producing homogeneous silicon carbide cobweb
whiskers easily and in good yield.

According to the present invention, there is
provided a method of producing silicon carbide cobweb
whiskers, which method comprises heating a mixture of
silicon dioxide powder, carbon powder and at least one of
niobium, tantalum and compounds thereof in an atmosphere
of non-oxidative gas at a temperature of from 1,400 to
1,900°C thereby producing silicon carbide cobweb whiskers
among the particles of unreacted carbon.

The silicon dioxide powders that can be used in the
present invention range from ultra fine powders having a

0179670

particle size of from 20 to 40 mμ, such as aerosil size particles, to large particles having a particle size of not more than 100 μm such as quartz sand and silicic anhydride. Among these powders, it is desirable to use large particles having a mean particle size of from 1 to 100 μm because they are easy to handle and are available at low cost.

Carbon powders that can be used include carbon black such as acetylene black and furnace black, and graphite carbon. From the viewpoint of handling, it is preferable to add the carbon material granulated to a granule size of from 0.3 to 1.5 mm, the material having its specific gravity raised by press-molding the carbon powder, after the other raw materials have been mixed. The amount of carbon powder added is preferably 0.6 part per part of silicon dioxide by weight or more. When the amount of carbon powder added is less than 0.6 part by weight, the result is that, in the reduction equation, $SiO_2 + 3C \rightarrow SiC + 2CO$, said amount is less than the equivalent amount so that unreacted silicon dioxide remains. On the other hand, when the amount of carbon powder added exceeds the equivalent amount, unreacted carbon usually remains in the silicon carbide fibrous material produced, and hence it is necessary to remove this unreacted carbon by heating the reaction mixture in an oxidative atmosphere. Although an excess of carbon powder increases the reaction speed, the addition of a large excess of carbon powder does not increase the reaction speed further. On the contrary, as the amount of unreacted carbon increases, the removal of the carbon becomes troublesome and more costly. Thus, the amount of carbon powder added is preferably within the range of from 0.6 to 3 parts by weight.

Examples of the niobium, tantalum, and compounds thereof that can be used as a catalyst include metallic niobium, metallic tantalum, niobium pentoxide, tantalum pentoxide, fluoro potassium niobate, fluoro potassium tantalate, niobium carbide, tantalum carbide, niobium nitride and tantalum nitride, niobium pentoxide and tantalum pentoxide being preferred.

The catalyst components may be used alone or in combinations of two or more. The amount added is preferably from 0.0001 to 0.1 part by weight, based on the total weight of niobium and tantalum as elements, per part by weight of silicon dioxide powder. When the amount is less than 0.0001 part by weight, the effect as a catalyst is not as remarkable, and, in addition to silicon carbide cobweb whiskers, silicon carbide powder begins to form as a by-product. When the amount is more than 0.1 part by weight, the amount of expensive niobium, tantalum, or compounds thereof becomes too great and, in addition, increases the contamination of niobium and/or tantalum carbide into the silicon carbide cobweb whiskers produced. Accordingly, an amount higher than 0.1 part by weight is not desirable. The more preferred amount is within the range of from 0.0005 to 0.03 part by weight.

The silicon dioxide powder, carbon powder, and the one or more catalyst components are mixed before being subjected to the reaction.

The choice of mixing means is not particularly restricted, and a ball-mill, ceramic kneader or the like may be used. As the mixing method, either a dry-mixing or a wet-mixing method may be used. However, it is desirable to add water and/or an alcohol together with the above-mentined powders and to mix them by means of a ball-mill in the wet to achieve more homogeneous mixing. In the wet-mixing, it is necessary to dry the mixture obtained. When, in drying, silicon dioxide power, carbon powder, etc., become separated owing to a difference in specific gravity of the individual raw materials, it is preferable to use eg a spray-dryer or a rotary evaporator.

This mixture is subjected to a reductive cabonization reaction by heat-treatment in an atmosphere of non-oxidative gas at a temperature of from 1,400 to 1,900°C, and preferably at from 1,450 to 1,800°C.

At a temperature below 1,400°C, long periods of reaction time are required to advance the reaction sufficiently. On the other hand a temperature above 1,900°C leads to an increase in energy costs in addition to a reduction in the yield of the final product. Accordingly, the use of a high temperature is not preferred for industrial use.

In other words it is most suitable also from an economic point of view to maintain a temperature of from 1,450 to 1,800°C for from 2 to 6 hours.

As the non-oxidative gas used in the heat-treatment, there may preferably be used argon, hydrogen or a mixture thereof. However, a gas mixture having as a major component argon and/or hydrogen and as a minor component carbon monoxide, nitrogen, ammonia, or the like may also be used. Further, a nitrogen-containing gas such as nitrogen or ammonia can be used alone, but in this case it is preferable to carry out the heat-treatment at a temperature of from 1,600 to 1,800°C because silicon nitride fiber contaminates the silicon carbide cobweb whiskers when the heat-treatment temperature is below 1,600°C.

With the heat-treatment cobweb whiskers grow among the unreacted carbon powder particles and a mixture of cobweb whiskers and residual carbon is obtained. To remove the residual carbon, it is desirable to carry out a further heat-treatment in an atmosphere of oxidative gas such as oxygen or air, a suitable heat-treatment temperature usually being from 600 to 800°C, and the treatment time from 1 to 4 hours.

The silicon carbide cobweb whiskers produced in the present invention have a mean diameter of from about 0.1 to 1.0 μm. However, the length of whiskers cannot be easily determined, because the whiskers are intertwined as shown in the accompanying photograph.

According to the present invention, silicon carbide cobweb whiskers can be advantageously produced on an industrial scale, and subsequently used for fiber reinforced composites, thermal insulators, and the like.

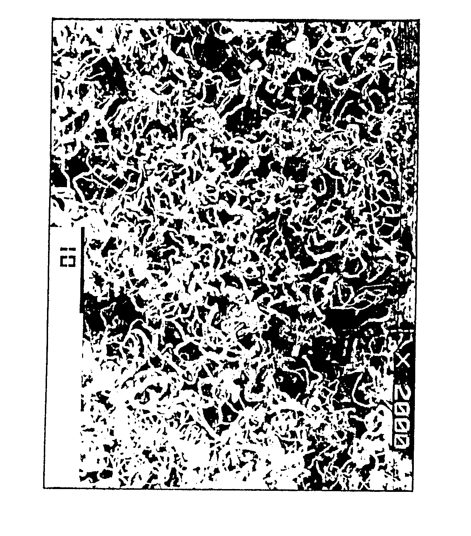

Next, the present invention will be illustrated with reference to the following Examples and the accompanying drawing which is a photograph obtained with an electron microsope at 2,000 magnifications of silicon carbide cobweb whiskers produced according to the present invention; in the photograph the length of the solid line corresponds to a distance of 10 μm.

### EXAMPLES 1 to 5

As a silicon dioxide powder, a commercially available quartz sand (mean particle size: 6 μm; BET specific area: 1.2 $m^2$/g) was used. As a carbon powder, a press-molded product of commercially available acetylene black was used. As compounds of Nb and Ta, powdery $Nb_2O_5$ and $Ta_2O_5$ were used respectively.

These powders were mixed in proportions as shown in Table 1. After addition of water, the mixture was charged into a ball-mill composed of plastic-coated balls and a plastic pot, and subjected to a wet ball-mill mixing for 2 hours. The resulting slurry-form mixture was charged into a rotary evaporator and dried with heating under reduced pressure while rotating the evaporator.

The dried mixture was charged into a graphite vessel and heated at 1,500 or 1,600°C for 4 or 6 hours while passing an argon gas therethrough, thus being subjected to reduction carbonization.

Further, the product obtained was heated at 700°C for 4 hours in air to remove the unreacted carbon and to obtain silicon carbide cobweb whiskers. The thus obtained silicon carbide fibrous materials were cobweb whiskers and contained no powder at all and showed a very low bulk density, as indicated in Table 1.

The cobweb whiskers obtained in Example 1 are shown in the accompanying photograph.

### COMPARATIVE EXAMPLES 1 to 3

Comparative Examples 1 to 3 were carried out in the same manner as in Examples 1 to 5, except that $Fe_2O_3$ was added to the silicon dioxide and carbon powders used in Examples 1 to 5 in proportions as shown in Table 1.

The product obtained in each of Comparative Examples 1 to 3 was a mixture of a silicon carbide fibrous material and a silicon carbide powder, and the bulk density of the product was larger than that of the silicon carbide cobweb whiskers obtained in Examples 1 to 5.

TABLE 1

| | Material (part by weight) | | | | | Reaction Condition | | Characteristics of Product | |
|---|---|---|---|---|---|---|---|---|---|
| | $SiO_2$ | C | $Nb_2O_5$ | $Ta_2O_5$ | $Fe_2O_3$ | Temperature (°C) | Time (hr) | Product | Bulk Density $(g/cm^3)$ |
| Example 1 | 1 | 0.6 | 0.01 | – | – | 1,500 | 6 | SiC cobweb whiskers | 0.04 |
| Example 2 | 1 | 0.6 | 0.005 | – | – | 1,600 | 4 | ditto | 0.05 |
| Example 3 | 1 | 0.6 | – | 0.01 | – | 1,500 | 6 | ditto | 0.05 |
| Example 4 | 1 | 0.6 | – | 0.005 | – | 1,600 | 4 | ditto | 0.04 |
| Example 5 | 1 | 0.6 | 0.005 | 0.005 | – | 1,500 | 6 | ditto | 0.05 |
| Comparative Example 1 | 1 | 0.6 | – | – | 0.01 | 1,500 | 6 | mixture of SiC particles and fibrous material | 0.20 |
| Comparative Example 2 | 1 | 0.6 | – | – | 0.005 | 1,600 | 4 | " | 0.18 |
| Comparative Example 3 | 1 | 0.6 | – | – | 0.02 | 1,600 | 6 | " | 0.17 |

0179670

CLAIMS

1. A method of producing silicon carbide cobweb whiskers by reductive carbonisation of silicon dioxide characterised in that a mixture of a silicon dioxide powder, a carbon powder and a catalyst composed of at least one of niobium, tantalum and compounds thereof is heated in a non-oxidative gas at a temperature of from 1,400 to 1,900°C, to produce silicon carbide cobweb whiskers among particles of unreacted carbon.

2. A method according to claim 1, wherein the amount of carbon powder is from 0.6 to 3 parts per part of said silicon dioxide powder by weight.

3. A method according to claim 1 or 2, wherein the amount of catalyst is from 0.0001 to 0.1 part, based on the total weight of niobium and tantalum as elements, per part by weight of said silicon dioxide powder.

4. A method according to claim 1, 2 or 3, wherein the mixture is heated at a temperature of from 1,450 to 1,800°C in an atmosphere of argon and/or hydrogen.

5. A method according to claim 1, 2 or 3, wherein the mixture is heated at a temperature of from 1,600 to 1,800°C in an atmosphere of a nitrogen-containing gas.

6. A method according to claim 5, wherein the nitrogen-containing gas is nitrogen and/or ammonia.

7. A method according to any preceding claim, wherein the unreacted carbon is removed by subsequently heating the mixture of silicon carbide cobweb whiskers and unreacted carbon at a temperature of from 600 to 800°C in an atmosphere of oxidative gas.

8.    A method according to claim 7, wherein the oxidative gas is oxygen or air.

9.    A method according to any preceding claim, wherein the catalyst is composed of at least one of niobium pentoxide and tantalum pentoxide.

10. Silicon carbide cobweb whiskers having a mean diameter of from 0.1 to 1.0 μm.